# EUROPEAN PATENT APPLICATION

(11) **EP 1 435 765 A1**
(43) Date of publication of application: **07.07.2004**
(21) Application number: 03250043.1
(22) Date of filing: 03.01.2003
(51) Int. Cl.: H05K 3/24, H05K 3/40, H05K 3/46

(54) **Method of forming connections on a conductor pattern of a printed circuit board**

(71) Applicant: Ultratera Corporation, Hsin-Chu (TW)
(72) Inventor: Chih, Wan-Kuo, Judung Jen, Hsinchu, Taiwan (TW)
(74) Representative: Vigars, Christopher Ian

(57) **Abstract**

A method of making connections on a conductor pattern of a PCB comprises the steps of: a) Prepare a substrate with a conductive layer at a side thereof. b) Form the conductive layer to a conductor pattern having first portions and second portions, wherein the first portions and a second portions have difference in height, and c) Provide an insulating layer on the substrate for sheltering the second portions of the conductor pattern but exposing the first portions of the conductor pattern. The first portions can plate Ni-Au layers on the exposed parts thereof to form interconnections to electrically connect the conductor pattern with another electronic device. The first portion also can be interfacial connections to connect the conductor patterns at different layers in a multi-layer PCB.

## Description

### FIELD OF THE INVENTION

The present invention relates to electronic industry, and more particularly to a method of forming connections on a printed circuit board (PCB).

### BACKGROUND OF THE INVENTION

In a conventional PCB, there always were connections, interconnections or interfacial connections, on a conductor pattern thereof to electrically connect the conductor pattern to another electronic devices or another conductor pattern.

A conventional method of making the interconnections was that remove the specific part of a solder mask of the PCB to expose the specific portion of the conductor pattern, and then plate Ni-Au layers on the exposed conductor pattern to form the interconnections. The interconnections, we called them as "bonding pads", can be electrically connected with another electronic device by solder jointing, wire bonding or by direct connection. The interconnection also can be bump pads with which bare chips can be connected thereto by direct chip attach (DCA).

Plating method was popular in making interfacial connections in a multi-layer PCB for electrical connection circuits on different layers such that we always found blind via, buried via or plated through hole therein.

The conventional plated connections usually have lands on the surface of the substrate. They took larger space of the PCB such that the conductor pattern had to increase the pitch between two traces. It is harmful to make the PCB into a smaller size. The plated connections also have some problems, such as tough process control on copper-reduction or hole-filling, poor adhesion caused by incomplete cleaning the smear on the side wall of the via, and registration error of the via due to the shrinkage or expansion of conductor patterns etc. That will make the PCB having higher proportion of defective.

### SUMMARY OF THE INVENTION

The primary object of the present invention is to provide a method of making connections on a conductor pattern of a PCB, which take less space of the PCB.

The secondary object the present invention is to provide a method of making connections on a conductor pattern of a PCB, which manufactures the PCB having a lower proportion of defective.

According to the objects of the present invention, a method of making connections on a conductor pattern of a PCB comprises the steps of:
a) Prepare a substrate with a conductive layer at a side thereof.
b) Form the conductive layer to a conductor pattern having at least a first portion and second portions, wherein a surface of the first portion is higher than the surfaces of the second portions, and
c) Provide an insulating layer on the substrate for sheltering the second portions of the conductor pattern but exposing the first portion of the conductor pattern.

### BRIEF DESCRIPTION OF THE DRAWINGS

FIG. 1 is a flow chart of a preferred embodiment of the present invention;
FIG. 2 is a sectional view of the preferred embodiment of the present invention, showing a substrate with a conductive layer thereon;
FIG. 3 is a sectional view of the preferred embodiment of the present invention, showing the conductive layer is made into a conductor pattern having first portions and second portions;
FIG. 4 is a sectional view of the preferred embodiment of the present invention, showing an insulating layer sheltering the second portions but exposing the first portion;
FIG. 5 is a sectional view of the preferred embodiment of the present invention, showing a first way to form the first portions and the second portions;
FIG. 6 to FIG. 9 are sectional views of the preferred embodiment of the present invention, showing a second way to form the first portions and the second portions;
FIG. 10 to FIG. 12 are sectional views of the preferred embodiment of the present invention, showing three formats of the first portions being exposed;
FIG. 13 to FIG. 15 are sectional views of the preferred embodiment of the present invention, showing a build-up process is applied on the substrate, and
FIG. 16 is a sectional view of the preferred embodiment of the present invention, showing the exposed portions of the first portions are plated with Ni-Au layers.

### DETAIL DESCRIPTION OF THE INVENTION

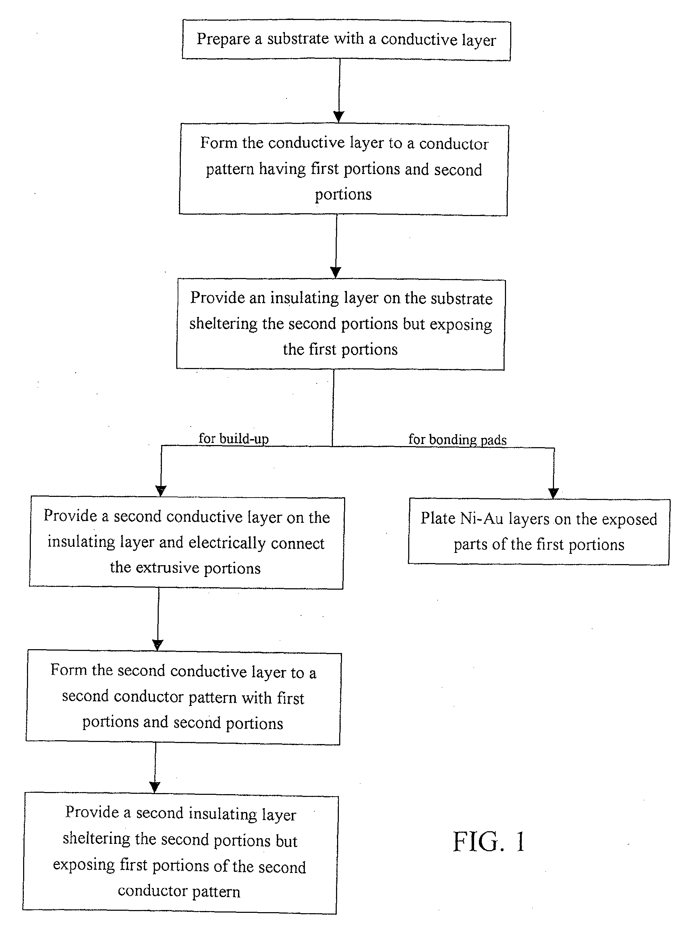

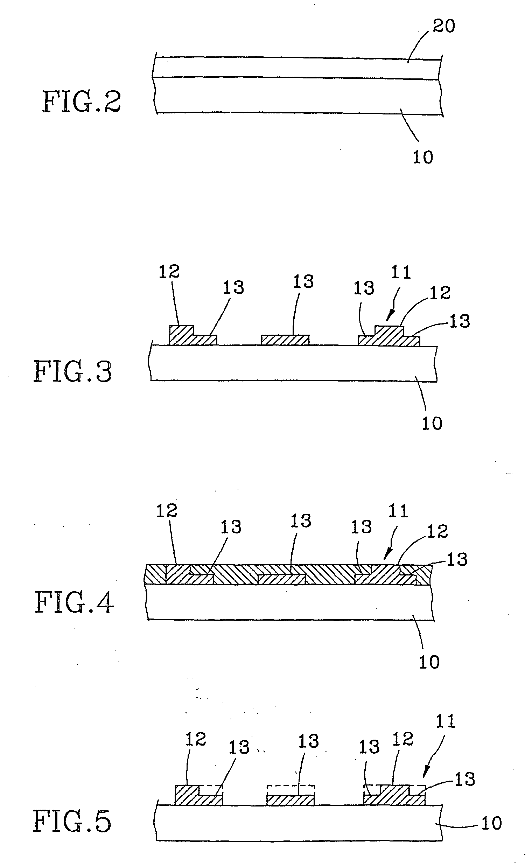

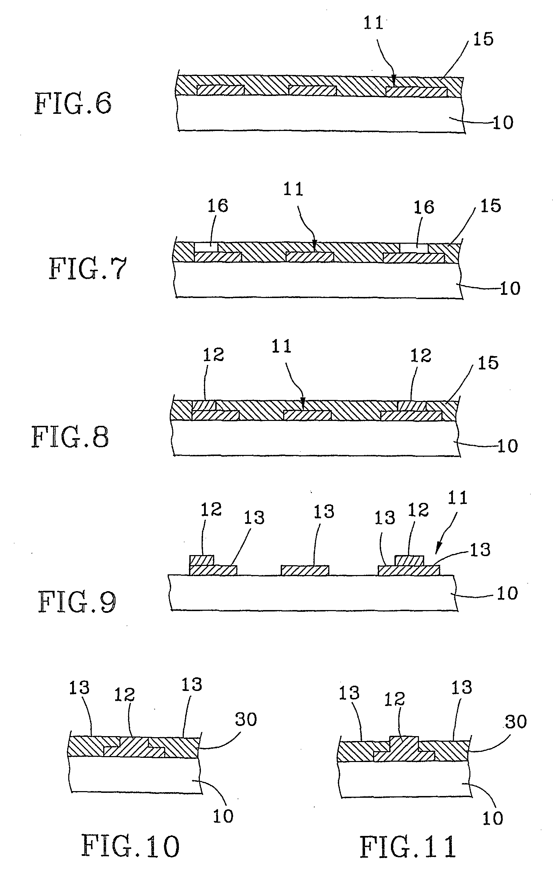

Please refer to FIGS. from FIG. 1 to FIG. 4, a method of making connections on a conductor pattern of a printed circuit board (PCB) comprises the steps of:
a) Prepare a substrate 10 with a conductive layer 20 at a side thereof.
   Please refer to FIG. 2, the substrate 10 is made of base material, such as multi-function epoxy resin etc. The conductive layer 20 is a copper foil fastened on the substrate 10.
b) Form the conductive layer 20 to a conductor pattern 21 having first portions 22 and second portions 23.
   Please refer to FIG. 3, the known photochemical processes are applied to the conductive layer 20 to etch the unnecessary parts of the conductive layer 20 out to form the conductor pattern 21 with a specific layout. The conductor pattern 21 has first portions 22 and second portions 23, wherein the first portions 22 like posts standing on the second portions 23, i.e., the first portions 22 and the second portions 23 are different in height and the surfaces of the first portions are higher than the surfaces of the second portions.
   The present inventors disclose two ways of disposing the first portions 22 and the second portions 23 of the conductor pattern 21 hereunder:
   b1) Please refer to FIG. 5 provide a copper foil with larger thickness on the substrate 10 first, and then remove selective areas (shown as the dot lines in the FIG.) of the copper foil to make it thinner, therefore, the portions of the copper foil being thinned will be the second portions 23 and the unthinned portions thereof will be the first portions 22.
   b2) Please refer to FIG. 6, coat a mask layer 15 (such as dry film) onto the substrate 10, and then conformal opening the mask layer 15 to dispose vias 16 (FIG. 7). Next, plate copper to fill the vias 15 (FIG. 8). At last, please refer to FIG. 9, remove the mask layer 15, such that the plated coppers will be the first portions 22 and the rest will be the second portions 23.

   It has to be mentioned here, the first portions 22 and the second portions 23 can be disposed before patterning the conductor pattern 21, it also can be done by disposing the first portions 22 and the second portions 23 after the conductor pattern 21 had been patterned.
c) Please refer to FIG. 4, apply an insulating layer 30 onto the substrate 10 for sheltering the second portions 23 of the conductor pattern 21 but exposing the distal ends of the first portions 22 of the conductor pattern 21.

The insulating layer 30 can be made from masking material, such as multi-function epoxy resin etc. The insulating layer 30 can be disposed on the substrate 10 by coating and laminating etc. The insulating layer 30 also can be disposed by attaching a resin coated copper foil (RCC) as the inventors' earlier invention (US Pat. 6,395,625) disclosed.

The methods of exposing the first portions 22 after the insulating layer 30 had been set are:
1. Scrub the surface of the insulating layer 30.
2. Plasma etch the surface of the insulating layer 30.
3. Conformal open the insulating layer 30 at the portions above the first portion 22 by laser shot or by plasma etching.
4. Carefully control the thickness of the insulating layer 30 when coating or laminating to make the insulating layer 30 unsheltered the first portion 22 directly.

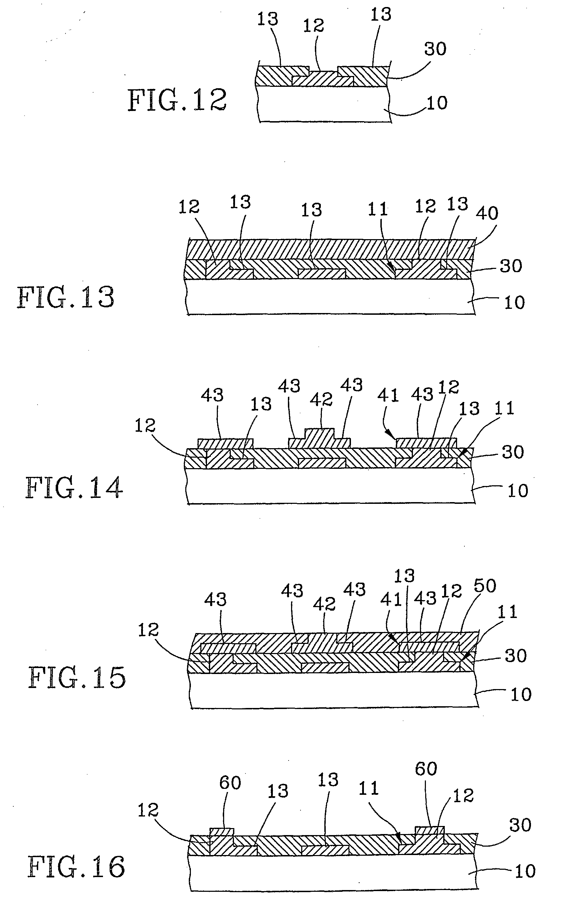

FIG. 10 to FIG. 12 show the perspective views of the exposed first portions 22 of the PCB of the present invention made from the methods above. Method 1, 2 and 4 might make the first portion 22 like FIG. 10 (the distal ends of the first portions 22 located at the same level of the surface of the insulating layer 30). Method 2 and 4 might make the first portion 22 like FIG. 11 (the distal ends of the first portions 22 extruded out of the insulating layer 30). Method 3 will make the first portion 22 like FIG. 12 (the distal ends of the first portions 22 under the surface of the insulating layer 30).

It has to be mentioned that the drawings of the preferred embodiment of the present invention shows the substrate 10 is provided with a conductor pattern 21 only at one side thereof. In practice, it should prepare a substrate with a conductor pattern at both sides thereof (not shown) and with plated through holes (PTHS) (not shown) in the substrate to electrically connect the circuits on the opposite sides. Aforementioned step b and step c are applied to the conductive layers on the opposite sides of the substrate to form a double sided PCB.

If the method of the present invention is applied to a build-up process, please refer to FIG. 13 to FIG. 15, it would chemical plate and electrically plate (depends on the requirement) a second conductive layer 40 onto the surface of the insulating layer 30 for electrical connection with the first portions 22 of the conductor pattern 21. Then, aforementioned step b and step c are applied to the second conductive layer 40 such that there will be a second conductor pattern 41 and a second insulating layer 50 on the insulating layer 30. Similarly, the second conductor pattern 41 has first portions 42 and second portions 43 and the second insulating layer 50 shelters the second portions 43 but exposing the first portions 42. It can repeatedly apply the step b and step c to form a third layer, a fourth layer and more on the PCB. The first portions 22 and 42 will be interfacial connections for electrically connection the conductor patterns on different layers.

The methods of forming the second conductor pattern 41, the first and the second portions 42 and 43 and the second insulating layer 60 and the methods of exposing the first portions 42 of the second conductor pattern 41 out of the second insulating layer 60 are as same as the methods described above, so I will not describe the detail again.

If the method of the present invention were applied to make interconnections, such as golden fingers or bonding pads, please refer to FIG. 16, it would simply plate Ni-Au layers 60 on the exposed parts of the first portions 22.

The advantages of the present invention are:
1. The dimensions of the vias at the insulating layer 30 for receiving the first portions 22 therein is smaller than the dimensions of the conventional plated vias (such as blind via, buried via or plated through hole) and no land is needed on the conductor pattern to connect the plated via with the conductor pattern, i.e., there will be a landless conductor pattern being provided on the PCB of the present invention, so that the PCB can be designed as smaller as possible.
2. The solid first portions have fewer problems to overcome in connection with the conductor pattern and in registration such that the PCB will has lower proportion of defective. In addition, we also found the solid first portions have well capacity of thermal strength such that they are not easily broken and they also have well adhesion with the conductor pattern and the insulating layer. Most of all, the present method provides a higher reliability in manufacture.
3. The method of the present invention is very simple and it can be applied to both in build-up processes and making the interconnections.

## Claims

1. A method of forming connections of a conductor pattern of a printed circuit board, comprising the steps of:
preparing a substrate with a conductive layer thereon;
forming said conductive layer to a conductor pattern with a specific layout, wherein conductor pattern has at least a first portion and second portions and a surface of said first portion is higher than surfaces of said second portions, and
providing an insulating layer on said substrate sheltering said second portions of the conductor pattern and unsheltering said first portion of the conductor pattern.

2. The method as defined in claim 1, wherein said first portion and said second portions are formed on said conductive layer first before said conductor pattern is formed.

3. The method as defined in claim 1, wherein said first portion and said second portions are formed after said conductor pattern had been formed.

4. The method as defined in claim 2, wherein said first portion and said second portions are formed by thinning selective portions of said conductive layer or said conductor pattern to form said second portions at the thinned portions and the rest is said first portion.

5. The method as defined in claim 2, wherein said first portion and said second portions are formed by providing a masking layer on said substrate sheltering said conductive layer, and then disposing at least a via at the selective position of said mask layer, and then plating conductive material to fill said via for electrically connected with said conductive layer, and then remove said mask layer, such that said plated conductive material will be said first portion and the rest will be said second portions.

6. The method as defined in claim 3, wherein said first portion and said second portions are formed by thinning selective portions of said conductor pattern to form said second portions at the thinned portions and the rest is said first portion.

7. The method as defined in claim 3, wherein said first portion and said second portion are formed by providing a masking layer on said substrate sheltering said conductor pattern, and then disposing at least a via at the selective position of said mask layer, and then plating conductive material into said via for electrically connected with said conductor pattern, and then remove said mask layer, such that said plated conductive material will be said first portion and the rest will be said second portions.

8. The method as defined in claim 1, wherein said first portion is exposed by scrubbing the surface of said insulating layer.

9. The method as defined in claim 1, wherein said first portion is exposed by etching the surface of said insulating layer.

10. The method as defined in claim 1, wherein said first portion is exposed by conformal opening said insulating layer at the portion thereof above said first portion.

11. The method as defined in claim 1, wherein said first portion is exposed by controlling the thickness of said insulating layer to make said first portion is exposed directly after providing said insulating layer on said substrate.

12. The method as defined in claim 1, further comprising the steps of:
providing a second conductive layer on the surface of said insulating layer to be electrically connected with said first portion;
forming said second conductive layer to a second conductor pattern with a specific layout, wherein said second conductor pattern has an first portion and a second portion and a surface of said first portion is higher than surfaces said second portions, and
providing a second insulating layer sheltering said second portions of the second conductor pattern and unsheltering said first portion of the second conductor pattern.

13. The method as defined in claim 1, further comprising the step of provided a Ni-Au layer on the exposed portion of said first portion.

14. The method as defined in claim 1, wherein the exposed surface of said first portion and the surface of said insulating layer are located at same level.

15. The method as defined in claim 1, wherein the distal end of said first portion is under the surface of said insulating layer.

16. The method as defined in claim 1, wherein the distal end of said first portion is higher than the surface of said insulating layer.

17. The method as defined in claim 7, wherein the plated conductive material could be same or different material from conductor pattern, such that the said first portion may content several conductive materials.
